# EUROPÄISCHE PATENTANMELDUNG

(11) **EP 4 618 329 A1**
(43) Veröffentlichungstag der Anmeldung: **17.09.2025**
(21) Anmeldenummer: 25163309.5
(22) Anmeldetag: 12.03.2025
(51) Int. Cl.: H02B 1/34, H05K 7/14, H02B 1/46, H02B 1/36

(54) **BAUGRUPPENTRÄGER**

(30) Priorität: 12.03.2024 DE 102024106969
(71) Anmelder: Deutsche Bahn AG, 10785 Berlin (DE)
(72) Erfinder: Uebel, Jens, 08645 Bad Elster (DE)

(57) **Zusammenfassung**

Es wird ein Baugruppenträger (10) mit einem einen Innenraum (20) umgebenden Gehäuse (11) bereitgestellt, wobei das Gehäuse (11) eine zum Innenraum (20) gewandte Innenfläche (12) und eine nach außen gewandte Außenfläche (13) aufweist. Erfindungsgemäß umfasst das Gehäuse (11) eine Abdeckung (19) und ist in der Weise ausgebildet, dass die Innenfläche (12) und die Außenfläche (13) voneinander elektrisch isoliert sind.

## Beschreibung

Die vorliegende Erfindung betrifft einen Baugruppenträger nach dem Oberbegriff des Anspruchs 1, sowie einen Schaltschrank mit diesem Baugruppenträger.

Baugruppenträger sind im Stand der Technik bekannt. So zeigt beispielsweise die DE 4200836 C1 ein Gehäuse zum Einbau von Anreih-Installationsgeräten, wobei zwei Seitenwände mittels einer mit Einführungsdurchbruch versehenen Rückwand miteinander verbunden sind, wobei an den Vorderkanten der Seitenwände nach außen weisende Befestigungsflansche angeformt sind, wobei auf den einander zugekehrten Innenseiten der Seitenwände senkrecht zur Rückwand einstell- und festlegbare Befestigungswinkel mit gegeneinander gerichteten Befestigungsflanschen angebracht sind, wobei an den Befestigungsflanschen der Befestigungswinkel eine Montageschiene zum Aufsetzen der Anreih-Installationsgeräte befestigt ist, und wobei eine im Querschnitt U-förmige Haube den offenen Raum zwischen den Seitenwänden dreiseitig abdeckt.

Die DE 3417451 C2 offenbart ein quaderförmiges Einschub-Gehäuse für elektronische Geräte, insbesondere ein 19-Zoll-Gehäuse. Es ist an der Unterseite der Deckplatte und an der Oberseite der Bodenplatte mit Schienen zum Einschieben von Steckkarten, Modul-Einschüben und dergleichen versehen. Um derartige Gehäuse nicht mehr aus Einzelteilen zusammenmontieren zu müssen und um sowohl Gewicht wie auch Herstellungskosten zu sparen, besteht das Gehäuse mit Deckplatte, Bodenplatte, Seitenplatten und Schienen aus einem einstückigen Kunststoff-Spritzteil.

Die DE 7632332 U1 zeigt ein Einschubgehäuse für auf Schaltkarten angeordnete elektrische und/oder elektronische Bausteine mit Stirnplatten und einer zwischen diesen Stirnplatten angeordneten und die Schaltkarten abdeckenden Verkleidung, wobei die Stirnplatten durch an den vier Ecken angeordnete Streben miteinander verbunden sind, wobei die an den vier Ecken der Stirnplatten anliegenden Streben, an denen Vorrichtungen zur Halterung der Schaltkarten angeordnet sind, von der Verkleidung voll umgriffen sind, wobei die Verkleidung aus zwei die beiden Längsseiten abdeckenden Schalten besteht, die an den Streben befestigt sind und wobei die gegenüberliegenden Längskanten der Schalen einen einen Luftstrom durch das Einschubgehäuse ermöglichenden Abstand voneinander haben.

Die DE 9305939 U1 offenbart ein Einschubgehäuse für Leiterplatten zum Einsatz in Baugruppenträger, mit zwei seitlichen, quaderförmigen, lösbar miteinander verbundenen Gehäuseschalen gleicher Grundfläche, die mit ihren großen, offenen Seiten zueinander weisen und die Leiterplatte zwischen sich einschließen und an einer gemeinsamen schmalen Stirnseite ebenfalls offen sind, wobei die offene Stirnseite von einer Frontplatte abgedeckt ist, die mit den Gehäuseschalen lösbar verbunden ist, wobei die Frontplatte auf ihrer zur Leiterplatte weisenden Rückseite parallel und mit Abstand zueinander angeordnete, aufeinander zu weisende Haltebereiche aufweist, welche mit korrespondierenden Gegenbereichen der Gehäuseschalen in Eingriff stehen.

Die DE 29818279 U1 zeigt einen Bauelementesatz zur Verkleidung eines Baugruppenträgers, der an seiner Frontseite seitlich überstehende Befestigungsflansche aufweist, umfassend:
a) eine untersetzbare Bodenplatte, auf welcher der zu verkleidende Baugruppenträger aufliegt;
b) zwei seitlich an dem Baugruppenträger ansetzbare Seitenteile mit an deren Vorderkanten nach innen abgewinkelten Halteleisten, welche die Befestigungsflansche umgreifen;
c) eine auf den Baugruppenträger und die beiden Seitenteile aufsetzbare Deckplatte;
d) Befestigungsmittel, welche die Bodenplatte, die Seitenteile und die Deckplatte (6) miteinander lösbar verbinden.

Die DE 10 2007 046 913 A1 offenbart ein abdichtbares Leiterplattengehäuse, insbesondere zur Verwendung in Kraftfahrzeugen sowie eine zur Verwendung in dem Leiterplattengehäuse besonders gut geeignete Leiterplatte. Das Leiterplattengehäuse weist eine an einer Stirnseite des Gehäuses angeordnete verschließbare Einschuböffnung, zwei einander gegenüberliegende parallele Führungsschlitze zur Aufnahme entgegengesetzter Seitenränder einer Leiterplatte, sowie Klemmmittel zum Festklemmen der Leiterplatte in den Führungsschlitzen auf, während die Leiterplatte ein Substrat aus einem Harz- oder Kunststoffmaterial sowie mindestens ein aus dem Harz- oder Kunststoffmaterial des Substrats bestehendes, einstückig mit dem Substrat verbundenes elastisch verformbares Federelement umfasst, das zum Festklemmen der Leiterplatte im Gehäuse und zum Toleranzausgleich mit den Klemmmitteln zusammenwirkt.

Der Erfindung liegt die Aufgabe zugrunde, einen verbesserten Baugruppenträger bereitzustellen.

Gelöst wird diese Aufgabe mit einem Baugruppenträger nach Anspruch 1 sowie einem Schaltschrank nach Anspruch 6. Vorteilhafte Weiterbildungen der Erfindung sind in den Unteransprüchen angegeben.

Bei dem erfindungsgemäßen Baugruppenträger mit einem einen Innenraum umgebenden Gehäuse, welches eine zum Innenraum gewandte Innenfläche und eine nach außen gewandte Außenfläche aufweist, umfasst das Gehäuse erfindungsgemäß eine Abdeckung und ist in der Weise ausgebildet, dass die Innenfläche und die Außenfläche voneinander elektrisch isoliert sind.

Damit ist vorteilhaft ein Baugruppenträger bereitgestellt, aus dessen Innenraum keine elektrisches Potential nach außen übertragen werden kann. Mit dem erfindungsgemäßen Baugruppenträger ist eine verstärkte oder doppelte Isolierung herstellbar. Der Baugruppenträger ist vorteilhaft verwendbar für Anforderungen der Schutzklasse II.

In einer vorteilhaften Ausgestaltung des erfindungsgemäßen Baugruppenträgers umfasst der Baugruppenträger zwei Halterungen zur Befestigung des Baugruppenträgers an einem Rack. Bevorzugt sind die Befestigungen für ein 19" Rack ausgelegt.

Damit ist der Baugruppenträger mit üblichen standardisierten Bauteilen kompatibel. Der erfindungsgemäße Baugruppenträger ist damit vielseitig einsetzbar und kann herkömmliche Baugruppenträger einfach ersetzen.

In einer weiteren vorteilhaften Ausgestaltung des erfindungsgemäßen Baugruppenträgers ist das Gehäuse aus einem Kunststoff gefertigt.

Damit ist die elektrische Isolation zwischen Innenfläche und Außenfläche auf einfache und Kostengünstige Weise hergestellt.

In einer weiteren vorteilhaften Ausgestaltung des erfindungsgemäßen Baugruppenträgers umfasst der Baugruppenträger eine im Innenraum angeordnete Trägerschiene.

Damit sind Reiheneinbaugeräte in einfacher Weise in dem Baugruppenträger arrangier- und fixierbar. Es können handelsübliche Reiheneinbaugeräte verwendet werden, womit vorteilhaft die Kompatibilität des erfindungsgemäßen Baugruppenträgers erhöht ist.

In einer weiteren vorteilhaften Ausgestaltung des erfindungsgemäßen Baugruppenträgers umfasst der Baugruppenträger Aufnahmeelemente zur Aufnahme der Trägerschiene, wobei die Aufnahmeelemente einstückig mit dem Gehäuse ausgebildet sind.

Damit ist die Anzahl der Einzelteile des Baugruppenträgers verringert, wodurch die Handhabung erleichtert ist.

Der erfindungsgemäße Schaltschrank mit einem einen Schrankinnenraum umgebenden Schrankgehäuse und einem im Schrankinnenraum angeordneten Rack, umfasst erfindungsgemäß einen an dem Rack befestigten erfindungsgemäßen Baugruppenträger.

Damit kommen die Vorteile des erfindungsgemäßen Baugruppenträgers dem Schaltschrank zugute.

Weitere Vorteile der vorliegenden Erfindung sind aus der detaillierten Beschreibung und den Abbildungen ersichtlich. Die Erfindung wird anhand der Abbildungen und der nachfolgenden Beschreibung näher erläutert. Es zeigen:
Fig. 1 einen erfindungsgemäßen Baugruppenträger in einer beispielhaften Ausführung in einer ersten Ansicht;
Fig. 2 den Baugruppenträger in einer zweiten Ansicht; und
Fig. 3 einen erfindungsgemäßen Schaltschrank in einer beispielhaften Ausführung.

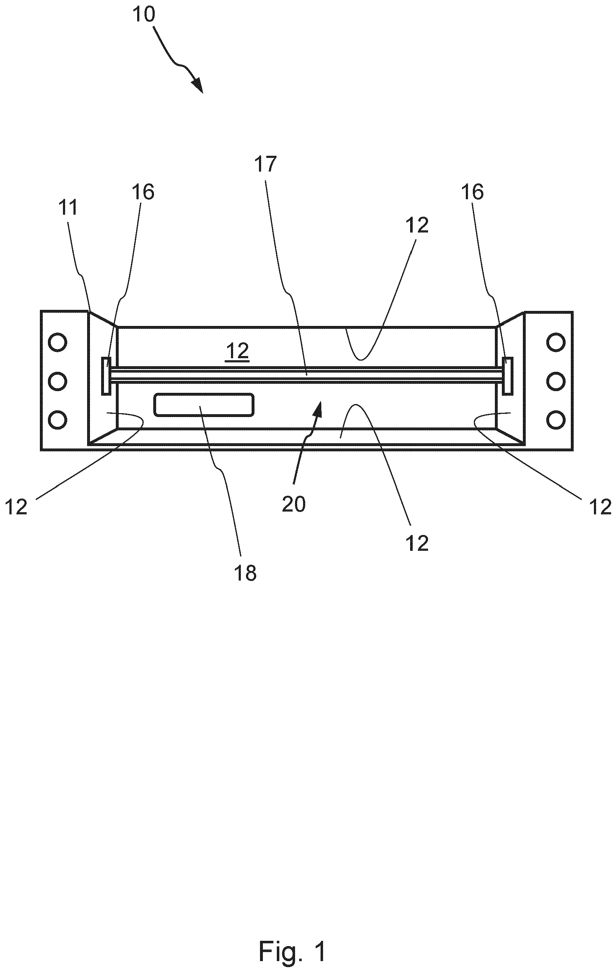

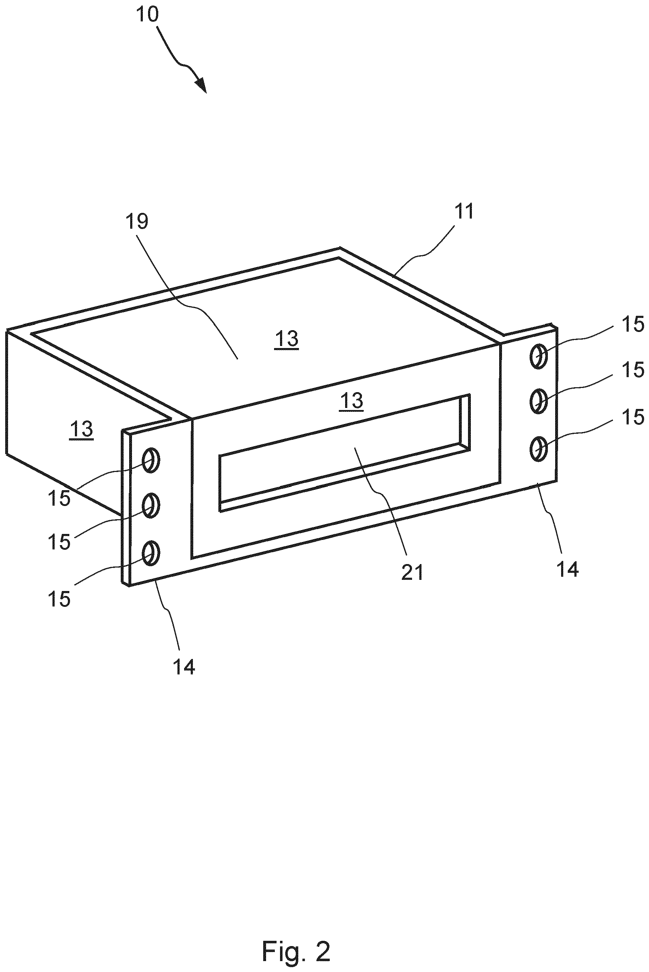

In den Figuren 1 und 2 ist der erfindungsgemäße Baugruppenträger 10 in einer beispielhaften Ausgestaltung in jeweils einer Ansicht schematisch dargestellt. Der Baugruppenträger 10 weist ein Gehäuse 11 auf, welches einen Innenraum 20 umgibt. Figur 1 zeigt den Baugruppenträger 10 ohne eine Abdeckung 19 mit Einblick in den Innenraum 20. Die Figur 2 zeigt den Baugruppenträger 10 aus einer anderen Perspektive mit der Abdeckung 19.

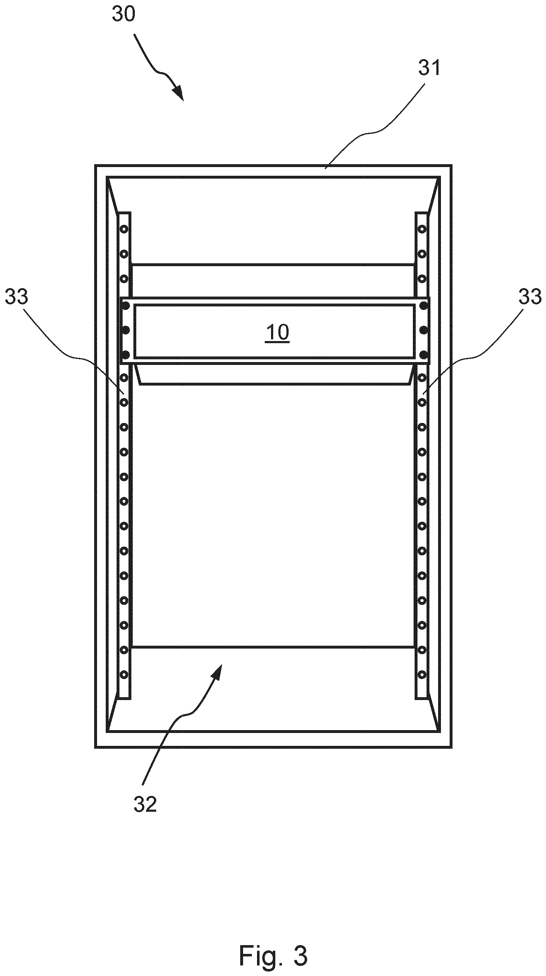

Der erfindungsgemäße Baugruppenträger 10 ist für einen Einbau in ein Rack 33, welches insbesondere ein 19"-Rack ist, ausgebildet. Dazu ist das Gehäuse 11 bevorzugt mit Halterungen 14 versehen. Die Halterungen 14 weisen insbesondere Befestigungselemente 15 auf, insbesondere Ausschnitte oder Löcher, die mit denen des Racks 33 korrespondieren. Mittels der Halterungen 14 ist der Baugruppenträger 10 an dem Rack 33 montierbar, welches insbesondere in einem Schaltschrank 30 angeordnet ist. In der Weise ist es in der Figur 3 skizziert.

Der erfindungsgemäße Baugruppenträger 10 weist das Gehäuse 11 auf. Das Gehäuse 11 umgibt den Innenraum 20. Die gesamte Fläche des Gehäuses 11, die zu dem Innenraum 20 gewandt ist, ist hier als Innenfläche 12 definiert. Die gesamte Fläche des Gehäuses 11, die nach außen gewandt ist, ist hier als Außenfläche 13 definiert. Mithin grenzt die Innenfläche 12 an den Innenraum 20. Die Abdeckung 19 ist ein Bestandteil des Gehäuses 11, der vom übrigen Gehäuse abnehmbar ist. Durch die abnehmbare Abdeckung 19 ist der Innenraum 20 zugänglich. Die Abdeckung 19 ist an das restliche Gehäuse 11 lösbar fixierbar, beispielsweise mittels Kunststoffschrauben. Die Abdeckung 19 weist in dem dargestellten Ausführungsbeispiel eine L-Form auf und öffnet das Gehäuse 11 an zwei Seiten. Es ist auch möglich, dass die Abdeckung 19 eine U-Form aufweist und das Gehäuse an drei Seiten öffnet. Daneben ist es auch möglich, dass die Abdeckung 19 das Gehäuse 11 an einer Seite, an vier oder fünf Seiten öffnet. Die Abdeckung 19 kann dabei auch mehrteilig aufgebaut sein.

In der Abdeckung 19 befindet sich bevorzugt eine Aussparung 21 für Reiheneinbaugeräte. Die Aussparung 21, ist, wie es üblich ist, mittels Abdeckstreifen an den Stellen verschließbar, an denen sich kein Reiheneinbaugerät befindet.

Erfindungsgemäß sind die Innenfläche 12 und die Außenfläche 13 voneinander elektrisch isoliert. Die Innenfläche 12 und die Außenfläche 13 sind mithin nicht miteinander elektrisch leitend verbunden.

Das Gehäuse 11 ist dazu bevorzugt zumindest an der Innenfläche 12 aus einem elektrisch isolierenden Material gefertigt, bevorzugt aus einem Kunststoff. Insbesondere ist das gesamte Gehäuse 11 aus Kunststoff gefertigt, insbesondere aus PVC.

Das Gehäuse 11 ist in alternativen Ausgestaltungen zumindest bereichsweise aus mehreren Schichten aufgebaut, wobei wenigstens die Schicht, auf der die Innenfläche 12 ausgebildet ist, aus einem elektrisch isolierenden Material gebildet ist. Insbesondere ist dabei die Schicht, auf der die Außenfläche 13 ausgebildet ist, auch aus einem Metall gefertigt. Ebenso sind hierbei insbesondere die Halterungen 14 aus einem Metall gefertigt. In einer weiteren alternativen Ausgestaltung ist das Gehäuse 11 aus einem Metallrahmen und einem Kunststoffkern gebildet, wobei der Innenraum 20 hierbei im Kunststoffkern ausgebildet ist.

Der Baugruppenträger 10 ist bevorzugt dazu ausgebildet, sogenannte Reiheneinbaugeräte aufzunehmen. Dazu verfügt der Baugruppenträger 10 bevorzugt über zumindest eine im Innenraum 20 angeordnete Trägerschiene 17. Auf der Trägerschiene 17 sind die Reiheneinbaumodule positionierbar. Die Trägerschiene 17 ist bevorzugt eine Hutschiene. Der Baugruppenträger 10 kann auch mehrere Trägerschienen 17 aufweisen.

Zur Anordnung der Trägerschiene 17 verfügt der Baugruppenträger 10 bevorzugt über zwei Aufnahmeelemente 16. Die Aufnahmeelemente 16 sind gegenüberliegend im Innenraum 20 angeordnet. Mittels der Aufnahmeelemente 16 ist die Trägerschiene 17 fixiert. Die Aufnahmeelemente 16 sind insbesondere einstückig mit dem Gehäuse 11 ausgebildet. Alternativ sind die Aufnahmeelemente 16 mit dem Gehäuse 11 verklebt und/oder in das Gehäuse 11 eingeschraubt oder eingeklickt.

Das Gehäuse 11 des Baugruppenträgers 10 weist bevorzugt zumindest eine Öffnung 18 auf. Die Öffnung 18 dient zur Durchführung zumindest eines Kabels. Der Baugruppenträger 10 umfasst zudem bevorzugt eine nicht dargestellte Zugentlastung für das zumindest eine Kabel. Die Zugentlastung leitet Zugkräfte, die am Kabel wirken in das Gehäuse 11.

Der Baugruppenträger 10 ist bevorzugt für einen Spannungsbereich bis 1000 V ausgelegt. Der Baugruppenträger 10 ist bevorzugt für 19" Systeme dimensioniert.

Der erfindungsgemäße Schaltschrank 30, der in der Figur 3 beispielhaft gezeigt ist, umfasst ein Schrankgehäuse 31, welches einen Schrankinnenraum 32 umgibt, sowie das Rack 33, welches im Schrankinnenraum 32 angeordnet ist. Das Schrankgehäuse 31 und das Rack 33 sind jeweils Stand der Technik. Das Schrankgehäuse 31 und das Rack 33 sind insbesondere elektrisch leitend miteinander verbunden. Das Schrankgehäuse 31 verfügt über einen Anschlusspunkt zum Potentialausgleich zum Erden des Schaltschranks 30. Erfindungsgemäß ist dem Schrankinnenraum 32 der zuvor beschriebene Baugruppenträger 10 angeordnet. Der Baugruppenträger 10 ist dabei mit seinen Halterungen 14 am Rack 33 befestigt.

### Bezugszeichenliste:

- 10: Baugruppenträger
- 11: Gehäuse
- 12: Innenfläche
- 13: Außenfläche
- 14: Halterung
- 15: Befestigungselement
- 16: Aufnahmeelement
- 17: Trägerschiene
- 18: Öffnung
- 19: Abdeckung
- 20: Innenraum
- 21: Aussparung
- 30: Schaltschrank
- 31: Schrankgehäuse
- 32: Schrankinnenraum
- 33: Rack

## Patentansprüche

1. Baugruppenträger (10) mit einem einen Innenraum (20) umgebenden Gehäuse (11), wobei das Gehäuse (11) eine zum Innenraum (20) gewandte Innenfläche (12) und eine nach außen gewandte Außenfläche (13) aufweist, **dadurch gekennzeichnet, dass** das Gehäuse (11) eine Abdeckung (19) umfasst und in der Weise ausgebildet ist, dass die Innenfläche (12) und die Außenfläche (13) voneinander elektrisch isoliert sind.

2. Baugruppenträger (10) nach Anspruch 1, wobei der Baugruppenträger zwei Halterungen (14) zur Befestigung des Baugruppenträgers (10) an einem Rack (33) umfasst.

3. Baugruppenträger (10) nach einem der vorherigen Ansprüche, wobei das Gehäuse (11) aus einem Kunststoff gefertigt ist.

4. Baugruppenträger (10) nach einem der vorherigen Ansprüche, wobei der Baugruppenträger (10) eine im Innenraum (20) angeordnete Trägerschiene (17) umfasst.

5. Baugruppenträger (10) nach Anspruch 4, wobei der Baugruppenträger Aufnahmeelemente (16) zur Aufnahme der Trägerschiene (17) aufweist, welche einstückig mit dem Gehäuse (11) ausgebildet sind.

6. Schaltschrank (30) mit einem einen Schrankinnenraum (32) umgebenden Schrankgehäuse (31) und einem im Schrankinnenraum (32) angeordneten Rack (33), **dadurch gekennzeichnet, dass** an dem Rack (33) ein Baugruppenträger (10) nach einem der vorherigen Ansprüche befestigt ist.
